# EUROPEAN PATENT APPLICATION

(11) **EP 3 598 507 A1**
(43) Date of publication of application: **22.01.2020**
(21) Application number: 18183695.8
(22) Date of filing: 16.07.2018
(51) Int. Cl.: H01L 31/048, H02S 20/20, H02S 20/21

(54) **TRANSPARENT DEVICE FOR COVERING SOLAR CELLS AND/OR AT LEAST ONE PHOTOVOLTAIC MODULE, COVERING SYSTEM, METHOD OF MANUFACTURING SUCH A DEVICE, PHOTOVOLTAIC SYSTEM AND METHOD OF GENERATING ELECTRICAL ENERGY**

(71) Applicant: Solmove GmbH, 10829 Berlin (DE)
(72) Inventor: Nadolny, Till, 10318 Berlin (DE); Müller-Judex, Donald, 14471 Potsdam (DE)
(74) Representative: Schulz Junghans Patentanwälte PartGmbB

(57) **Abstract**

The invention concerns a transparent device for covering solar cells and/or at least one photovoltaic module, and a method for producing at least one transparent device for covering solar cells and/or at least one photovoltaic module. In addition, the invention concerns a covering system for covering solar cells and/or at least one photovoltaic module with several devices according to the invention, as well as a photovoltaic system and a method for generating electrical energy using the photovoltaic system.

The transparent device has a base body (12) extending essentially in one plane, on the upper side (13) of which several structural elements (30) are arranged, each having at least one top surface (31) facing away from the upper side (13) of the base body (12), a maximum vertical extension H of a respective structural element (30) and a distance D of the respective structural element (30) from the adjacent structural element (30), with a ratio H/D which is limited by H/D < 6, in particular by H/D < 1.5.

## Description

The invention concerns a transparent device for covering solar cells and/or at least one photovoltaic module, and a method for producing at least one transparent device for covering solar cells and/or at least one photovoltaic module. In addition, the invention concerns a covering system for covering solar cells and/or at least one photovoltaic module with several devices according to the invention, as well as a photovoltaic system and a method for generating electrical energy using the photovoltaic system.

Photovoltaic technology is an important branch for the environmentally friendly and sustainable generation of electrical energy. Photovoltaic systems require a lot of space and should also be oriented essentially perpendicularly to the sunlight, suitable for a good energetic yield. Such systems are usually installed on south-facing roofs and slopes or mounted on fallow land.

The growing demand for environmentally friendly electrical energy prompts the search for additional space for the installation of photovoltaic systems. It is particularly desirable to make already sealed areas usable for energy production. Traffic areas such as roads, cycle paths, footpaths, parking lots and tracks represent a large total area of sealed surfaces.

The use of photovoltaic systems on these generally horizontal surfaces places special demands on the modules of the systems in order to be able to operate them with a high degree of efficiency despite the adverse conditions that exist. In particular, contamination or other deposits on the surface of the systems have an adverse effect on the energy yield.

Further, special challenges will arise if the above-mentioned areas are to remain available to traffic without restrictions. It should be noted, among other things, that the reflection of solar radiation on the surfaces of traffic routes is perceived by people as annoying glare. This poses a considerable risk potential in road traffic. In addition, such a device must be designed to withstand the mechanical stresses of road traffic and have the necessary anti-slip properties. Furthermore, it is desirable that the surface of the system should be designed in such a way that rolling noises of the tires are minimal.

Last but not least, for the purpose of economic use, it is necessary that the production of photovoltaic systems for the above-mentioned application can be carried out cost-effectively and that simple and error-free installation is possible. In addition, cost-effective maintenance, and repair is desirable.

Flat glass panels are usually used to cover photovoltaic modules consisting of several solar cells. As a rule, this is special solar glass. Solar glass is characterized by its low iron or iron oxide content compared to conventional window glass, preferably less than 0.05 percent by weight, making it particularly transparent and thus supporting a high efficiency of the module. Such a glass is described in WO 02/064518 A1. In addition, it is usually thermally or chemically hardened, which makes it more resistant to mechanical loads, such as hail, and has higher thermal shock resistance.

The efficiency of commercially available photovoltaic modules depends on how the active side of the system is oriented towards the sun. When the modules are aligned horizontally, the sunrays hit the surface at a flatter angle. The flatter the angle of incidence, the lower the transmission of the beams into the surface of the module, and the greater the reflection which entails blinding.

The flat glass panes covering the modules are naturally cleaned by rain. Cleaning of these systems is only necessary in special cases. The efficiency of these modules would be significantly reduced if installed horizontally due to dirt and standing liquid. They are thus preferentially installed at an angle to the surface of the earth.

Usually the covering flat glass panels are not designed for the mechanical loads of a traffic route, e.g. generated by a car or truck, and are not slip-resistant.

The WO 02/064518A1 shows a glass pane made of solar glass for application in photovoltaic technology which is characterized by structures in the µm range on the surface. Embossing is used to apply structures with a diameter of 200-800 µm and a peak-to-value of 20-50 µm to both the top and bottom of the glass pane. In addition, the glass is coated with an anti-reflective layer. The structures in the µm range increase transmission and reduce reflection in comparison to flat planes. In addition, dirt adheres less well to matt surfaces. Compared to single-sided structured and/or matt panes, double-sided structured panes have the advantage that they cannot be mounted the wrong way round. Disadvantageous in relation to the application described above is that the glass pane revealed in this publication does not offer any slip-resistance when walking on or driving on.

In architecture, walk-on glass panes and glass tiles are known for both indoor and outdoor use. They are used, for example, for the design of stairs, pedestrian bridges and false ceilings. Usually this is a multi-layer laminated glass with a corresponding thickness to ensure breaking resistance. In order to ensure the necessary slip resistance, the surfaces of walk-on glass are treated, e.g. by sandblasting, etching, screen printing or laser structuring. The disadvantage of such roughened surfaces is their susceptibility to soiling. Contamination that occurs is heavy and in some cases cannot be removed.

In WO 2015/021955 A1 an optically transparent surface for photovoltaic modules is disclosed which is to be laid on mechanically stressed horizontal surfaces. The invention requires a surface with a microstructure promoting the input of sunrays onto a photovoltaic layer attached to it, even at flat angles of incidence of the light. The surface structure shown there consists of individual, asymmetrical elevations. This means that the elevations have a flatter side curved upwards as a hump and a steeply sloping side. In addition, the WO 2015/021955 A1 reveals that at the highest point of each elevation there is a stopping point for vehicles. Furthermore, a coating of the surface is revealed there in order to give vehicles grip caused by friction.

It can be seen that with the hitherto known design of transparent solar cell covers it is not or at least not economically possible to meet the requirements regarding a high degree of efficiency and high strength properties of the covered solar cells.

The invention is therefore based on the task of providing a transparent device for covering solar cells and/or at least one photovoltaic module, a method for producing at least one transparent device for covering solar cells and/or at least one photovoltaic module, a covering system for covering solar cells and/or at least one photovoltaic module with several devices according to the invention and a photovoltaic system and a method for generating electrical energy by means of the photovoltaic system, which enable the generation of electrical energy by solar cells with high efficiency at low cost.

This task is solved by the transparent device according to the invention for covering solar cells and/or at least one photovoltaic module according to claim 1, by the covering system according to the invention according to claim 12, by the method according to the invention for producing a device according to the invention according to claim 13, as well as by a photovoltaic system according to claim 14 and by the method according to the invention for generating electrical energy by means of an photovoltaic system according to the invention according to claim 15. Advantageous embodiments of the transparent device according to the invention are indicated in subclaims 2-11.

A first aspect of the invention is a transparent device for covering solar cells and/or at least one photovoltaic module with a base body extending essentially in one plane, the upper side of which several structural elements are arranged, each having at least one top surface facing away from the upper side of the base body. The structural elements have a maximum vertical extension H and a distance D to the adjacent structural element. The ratio H/D is less than 6, in less than 1.5.

The device for covering solar cells or photovoltaic modules can also be called a tile or cover glass. The plane is defined by the orientation of the preferably essentially flat lower side of the device and extends horizontally in the x, y- direction whit is the standard orientation in the sense of the invention. The solar cells or photovoltaic modules to be covered are located directly on the lower side of the device.

The lower side of the base body is preferably square with an edge length between 50 mm and 120 mm. However, any other base area is also possible, such as a circle, an ellipse, a trapezium, an uneven rectangle or any other polygon. The maximum horizontal extension of the lower side of the base body in the plane should preferably not be more than 70 mm.

Several structural elements are arranged on top of the base body of the device. The base body is the entire device without the structural elements. It is not mandatory that the upper side of the base body is parallel to its base surface. In a preferred embodiment, the basic body is a cuboid.

For the purpose of mechanical stability, in particular high bending strength, the base body has a minimum thickness, in other words a minimum vertical extension in the z-direction measured vertically to the lower side of the base body to its upper side. In a preferred embodiment, the minimum thickness of the base body is 3 mm.

Structural elements are arranged on the upper side of the base body. The device can contain any number of structural elements. The distribution of structural elements on the upper side of the base body can be symmetrical and/or asymmetrical and/or random. Preferably, the upper side of the base body is completely covered with structural elements, mainly homogeneously distributed.

Each structural element has at least one top surface facing away from the upper side of the base body. In other words, the device is limited upwards by the top surfaces of the structural elements. The top surfaces of the structural elements are preferably form essentially in one plane parallel to the upper side of the base body and limited by the extension of the side surfaces of the structural elements. However, it is also possible that the top surface of one or more structural elements may be curved upwards. In special embodiment, it is intended that a structural element has more than one top surface subdivided for example by notches. Different structural elements with a different number of top surfaces can be arranged on one basic body. In a preferred embodiment, the majority of structural elements have two surfaces.

The structural elements are characterized by a maximum vertical extension H, in other words a maximum height H. The height H of a structural element is defined as the maximum vertical extension measured perpendicularly from the upper side of the base body. Preferably, all structural elements of a device have approximately the same height. However, it is possible that the height of the structural elements on the upper side of a device varies, whereby the height variation of the structural elements over the upper side of the base body can be regular and/or irregular.

Furthermore, the structural elements are characterized by their distance D to adjacent structural elements. The distance D is defined as the distance of the base points of two adjacent structural elements in a vertical section through two adjacent structural elements of the device. Adjacent structural elements are primarily those whose side surfaces are at least partially opposite to each other. The base point is the intersection of the extension of the side surface of a structural element with the upper side of the base body in said vertical section view. The distance D between two structural elements is preferably at least 0.5 mm.

The device is mainly used to cover solar cells and/or photovoltaic modules. The solar cells or photovoltaic modules are to be arranged on the lower side. In order to generate electrical energy by converting light, in particular daylight, using the solar cell located under the device, the light must penetrate the device. The base body and structural elements are therefore preferably essentially transparent.

In order to transmit a maximum amount of light through the device to the solar cells, in particular when the device is horizontally oriented and the angle of incidence of light is 90° to 30° or less from the horizontal plane, the H/D ratio should preferably be less than 6, more preferably less than 1.5, most preferably less than 1. In other words, the height of the structural elements should not be more than six times the smallest distance D between two adjacent structural elements. In a preferred embodiment, the H/D ratio of the structural elements of a device varies. The purpose of this is that the device can transmit light in an optimal way to the solar cells to generate energy, so that even a flat angle of incidence, in particular between 45° and 30° to the horizontally aligned upper side of the device, can be used efficiently. In a preferred embodiment of the device, the ratio H/D within a device varies in the value range between 0.4 and 4.

Each structural element has a base area. The base area of a respective structural element is generated by the vertical projection of the structural element on the horizontally aligned upper side of the base body. In other words, the base area is limited by the points of transition of a particular structural element to the base body. The base or projected area has a center of area.

The base area of a structural element is preferably designed as a rectangle, especially preferably as a square. However, any other base area is also possible, such as a circle, an ellipse, a trapezium, an uneven rectangle or any other polygon. Different base areas of structural elements can be arranged on a base body.

In a particularly preferred embodiment, the device includes, especially in the central region, in the majority of structural elements with a square base area, in the edge region structural elements with a triangular base area and in the corners structural elements whose base area results from a combination of square and triangle.

The base areas in the corner and edge regions of the device result from the fact that the upper side of the base body is essentially completely covered with structural elements. Lower side of the base body as well as the majority of the structural elements are square. The preferred arrangement of the structural elements in rows running essentially parallel to rows running through the corners of the device results in bigger gaps. These gaps are filled by edge elements and corner elements so that there are no large gaps between adjacent devices in the edge regions.

One preferred embodiment of the device is that the maximum vertical extension H of a structural element is at least 1.5 mm.

The maximum vertical extension of a structural element can also be described as height H. The height is measured from the upper side of the base body perpendicular in the z-direction.

In other words, the depth of the total structure formed by the sum of the volumes of the structural elements on the upper side of the base body, starting from the highest point of the top surface of the structural elements measured vertically in the direction of the upper side of the base body, is at least 1.5 mm, especially preferably at least 2 mm.

The height H of the structural elements can be configured differently. It is possible to arrange relatively flat structural elements, with a height H of approx. 5-8 mm, or to clearly scale the structural elements up to a height range of 15-25 mm.

The height H is essentially the same for all structural elements of a device. However, it is also possible that the heights of the structural elements or the depth of the overall structure may vary. It is also possible that the variation in height H is distributed regular or irregular over the upper side of the base body. Regular means, for example, a continuous increase or decrease in the height of the structural elements from the central region to the edge region of the device. An irregular distribution would be given, for example, by a random distribution.

In particular, the depth of the total structure serves the effective displacement of liquid, in particular water, when walking on and/or driving on the device, or the independent draining of liquid from the spaces between the structural elements. In other words, the structure depth supports the drainage of the device. Effective drainage of liquid and the expected soiling when used as intended also serves to effectively absorb and transmit light through the device and, as a result, to make more effective use of the underlying solar cells. Active cleaning of the device is also supported by the drainage properties of the device. In addition, the risk of slipping on the device by people walking and/or cars, bicycles or other vehicles driving on it is reduced by active cleaning.

In another preferred embodiment form the outward surfaces of structural elements and/or the base body are further characterized in that they are hydrophobically designed.

Essentially all surfaces of the device that are directed outward, except for the lower side of the base body. Outward-facing surfaces are exposed to the weather.

This hydrophobicity results either from the choice of the material from which the device is made and/or from an additional coating of the device. The hydrophobic design of the outwardly directed surfaces serves in particular to reduce the adhesive forces. That supports the effective drainage of liquids, especially water. This is particularly advantageous for high heights H and short distances D, as the closer and deeper the gap between two adjacent structural elements, the stronger the adhesive forces are.

In a further embodiment of the device, at least one side surface of a respective structural element is angled at least on a part of the circumferential surface of the respective structural element at an angle of at most 75° with respect to the upper side of the base body, so that the respective structural element tapers with increasing distance from the upper side of the base body.

The circumferential surface is the closed area, which is composed of the side surface or the side surfaces of a respective structural element. In the case of a square base area of a structural element, the circumferential surface is made up of the four equal side surfaces. Horizontal alignment refers to the intended arrangement of the device in space, as is typical for a road surface, for example. The angle at which the side surfaces are angled or inclined is measured from the upper side of the base body, which is aligned in the x-y-plane, in the direction of the z-axis to the side surface of the structural element. The maximum angle is 68°, preferably 65°.

It is possible that only parts of the sides are angled. In the preferred embodiment, however, all side surfaces and thus the entire circumferential surface taper with essentially the same angle in the z-direction.

It is also possible that the angle is not constant but decreases. In this case, the structural elements are formed in the form of bulges with convex side surfaces or convex circumferential surface. In the preferred embodiment, the angle at which the side surfaces taper is essentially constant.

Due to the preferred embodiment of the structural elements in combination with the preferred maximum extension H of the structural elements, it occurs that the structural elements, especially in the central region of the device, have the form of a frustum of a pyramid. The vertical section through the center vertical axis of a structural element shows a regular trapezium tapering upwards in the z-direction which is axis-symmetrical to a vertical central axis of the structural element.

Equivalent considerations apply to the edge elements and the corner elements.

There is a gap between two adjacent structural elements. Due to the taper of the structural elements, this gap widens continuously in the direction from the base body towards the top surface of the structural elements. In other words, the distance between the lateral sides of two adjacent structural elements at their base areas is smaller than the distance between the lateral sides of these two adjacent structural elements at their top surfaces.

The flatter the angle of incidence under which the light hits a glass surface, the higher is the reflection component. This is undesirable because on the one hand only the transmitted light component is available for energy generation in the solar cell and on the other hand the reflected light is perceived as disturbing glare. This effect is particularly relevant for horizontal installation. The angled side surfaces of the structural elements offer the advantage that the light yield is increased and the glare reduced by positioning the side surfaces at an angle.

In addition, the gap that narrows from the top surface of the structural elements downwards to the upper side of the base body serves to drain the device and improves the demolding of the device in the manufacturing process.

The device is also configured in a preferred way in that the transitions between upper side of the base body and/or the surfaces of the structural elements are formed with a fillet radius of at least 1 mm.

Transition means here, for example, the transition between the side surface of a structural element and upper surface of the structural element. Another example is the transition between the side surface of a structural element and the upper side of the base body. In other words, the device is preferably configured such that all corners and edges are rounded with a radius of at least 1 mm. It is possible that the radius is not the same for all transitions.

The advantage of rounding is essentially the better demolding of the device in the manufacturing process and to avoid sharp-edged corners.

In a further embodiment, the device is designed in such a way that at least one structural element has at least one notch on its respective top surface facing away from the upper side of the base body.

The notch, preferably in the central region of the structural element, extends from the top surface of the structural element vertically downwards in the direction of the base body. In other words, the notch forms an incision in the top surface of the structural element and subdivides the top surface in two top surfaces and. The notch is preferably designed in such a way that it narrows in with decreasing distance to the upper surface of the base body. The notch does not necessarily reach the base body. In the vertical section through center of the structural element, the notch forms a triangle, whereby the corners are preferably rounded. Furthermore, it is possible to arrange the notches in such a way that the resulting top surfaces are of the same size and/or shape. The notch may be aligned parallel to at least one side surface of the structural element.

In principle, it is possible that a structural element may have more than one notch or no notch. In a preferred embodiment the corner elements of the device have two notches and the structural elements in the edge region have no notch.

Preferably, more than half of all structural elements of a device have at least one notch.

The notches should preferably be designed in such a way that their maximum vertical extension from the top surface of a particular structural element towards the upper side of the base body does not exceed 2 mm. The preferred depth of a notch is 1 mm.

In a preferred embodiment, the notches of two adjacent structural elements are, at least on parts of the device, designed such that in the top view of the device the notch of a second, adjacent structural element runs at an angle of 90° to the notch of the first structural element.

The advantage of this pairwise perpendicular arrangement of the notches is that the no-slip properties of the device are increased.

In a preferred embodiment several structural elements are arranged in rows, at least some of these structural elements arranged in rows and adjacent to one another being staggered in relation to each other in such a way that a non-linear interpolation of the centers of gravity of their projection surface onto the upper side of the base body describes a second-order curve.

The projection surfaces of the structural elements on the upper side can also be called base areas of the structural elements. Structural elements with square base areas are preferred. In this case the arrangement in rows means that the side surfaces of adjected structural elements are essentially parallel. In the case of non-square base areas, the rows result from the arrangement of the base area centers of gravity of the structural elements on an essentially straight line.

In other words, a staggered arrangement of the structural elements means that the row arrangement does not exactly correspond to a straight line, but that there is a curvature in the row arrangement. It is possible that this is the case for all rows of elements in a device.

In a particularly preferred embodiment, the structural elements are arranged in such a way that the two diagonals on the upper side of the base body, which divide the upper side into four essentially triangular segments of equal size, are covered with structural elements in a row arrangement, running through the corner points of the device. Further, essentially parallel rows of structural elements are arranged on both sides of the diagonals. For the two diagonal rows of structural elements, the element base area centers of gravity are arranged on a straight line even with non-linear interpolation. For the remaining rows of structural elements, on the other hand, the base area centers of gravity are staggered in such a way that a second-order curve exists for non-linear interpolation of the base area centers of gravity. In the preferred embodiment, the curvature of the curve is small. It is convex in the direction of the central region of the device. The apexes of the interpolated curves lie on the diagonal running at right angles. The further the curved rows are arranged on the upper side away from the diagonal, the stronger the curvature. The apexes of the curves lie on the diagonals, which run from corner to corner on the upper side.

In other words, the structural elements that do not lie on the diagonals of the device are staggered and do not exactly align with their respective adjacent structural elements on that same diagonal. This results in an aperiodic arrangement of structural elements on part of the upper side of the base body. In a preferred embodiment at least 25% of the structural elements are arranged aperiodically on the upper side.

The advantage of this embodiment is a reduction of rolling noise when, for example, vehicles or bicycles drive on the device.

In another preferred embodiment, several structural elements form an element grid, wherein at least partially at least one channel is formed between the row arrangements of structural elements. The channel widens from a central region of the device in the direction of its edge region. The element grid or the overall structure results from the arrangement of the structural elements of a device on the upper side of the base body. A channel is a channel-like recess within the structure. A channel results from the arrangement of the structural elements in several rows. The central region of the device is characterized by the intersection of the diagonals of the upper side and the center of area of the upper side.

In a preferred embodiment, the structural elements on the diagonals of the device lie on a straight line, whereas the staggered arrangement of structure elements in the rows to the left and right of the diagonals describe curves of second order. In other words, the distance D between two adjacent structural elements in the central region of the device is smaller than in its edge region. In other words, the channel results from the lateral offset of the structural elements of the parallel row arrangement to the diagonal row of structural elements. This means that a channel in its preferred embodiment is not axis symmetrical to its main axis in the x-y-plane.

It is possible that a channel is also formed by two opposite rows with equal but opposite curvature.

The distance D between two adjacent structural elements of two adjacent rows increases continuously from the central region to the edge of the device. In a preferred embodiment, 8 channels are formed in this way. The ratio in which the distance D widens from the central region to the edge region is preferably at least 1:2, especially preferably between 1:4 and 1:2.

The distance between two adjacent structural elements D is preferably at least 0.5 mm, especially preferably at least 1 mm. The distance D is the shortest distance between the foot borders of two adjacent structural elements, whereby the foot border is the line in which the upper side of the base body intersects with the straight extension of the side surfaces of the structural elements.

The function of the channels is the effective drainage of water and pollution from the overall structure of the device. Furthermore, the shadowing between the structural elements, especially in low sunlight, is less pronounced in the edge regions due to the greater distance between the structural elements, which increases the absorption of light by the device and thus the energy yield.

In a further embodiment of the device, the structural elements are arranged on the device in such a way that the profile of the device in each vertical section along a vertical central axis of the device is substantially axially symmetrical to the vertical central axis of the device.

The vertical central axis runs perpendicular to the upper side of the base body through the center of area of the upper side. A device exactly symmetrical to the central axis of the device is particularly preferred.

In the preferred embodiment with a square upper side of the base body, this feature also means that the device comprises four essentially identical, particularly preferably exactly identical triangular segments.

The symmetrical design of the device ensures that the risk of incorrect installation, in the sense of incorrect alignment of the device in the x-y-plane, for example on a roadway, is minimized.

In a further embodiment, the device is characterized in that it consists at least in certain areas of a transparent material which has a transmittance of at least 0.8, in particular for daylight.

The transmittance is the ratio of the radiation power entering a medium to the radiation power incident on the medium. At a transmittance of 0.8, 80% of the light incident on the device enters the medium, while 20% is reflected or absorbed. Ideally, the transmittance of the device is 1.

Device with a high degree of daylight transmission are preferred. Daylight refers to natural sunlight, especially in the wavelength range of visible light from 300 to 800 nm, but is particularly preferred in the range including UV an IR.

Particularly preferred is a device made entirely of a transparent material, but at least the areas that serve to absorb daylight and pass it on to the solar cells located on the lower side. The degree of transmission for daylight should preferably exceed that of normal window glass. A degree of transmission for daylight greater than 0.9 is particularly preferred.

In particular, the device, and in particular the structural elements, may consist of a material with a Mohs hardness of at least 5.5 and/or an abrasion resistance of at least class 4.

For the intended use of the device for covering roadways for motor vehicles and/or footpaths and cycle paths, it is important that the abrasion of the device is minimized due to the associated stress on the material. Wear occurs during intended use, among other things, due to abrasion in connection with dirt such as small stones.

Strong wear of the device reduces its anti-slip properties and cleanability, but also the absorption capacity for light. The higher the possibility of abrasion of the device, the more often a cost-intensive replacement is necessary.

The structural elements in particular, but above all the top surfaces of the structural elements that are most exposed to the stresses of use, are therefore preferentially made of a material with a Mohs hardness of more than 5.5 or a material hardness equivalent to a Mohs hardness of 5.5. Particularly preferred is the case of the entire device consisting of a material of appropriate hardness.

In addition, the top surfaces of the structural elements in particular have an abrasion resistance of at least class 4, especially preferably class 5, in accordance with DIN EN 176. Materials that are abrasion-resistant according to class 4 withstand the stress of normal footwear in combination with dirt even during heavy use.

The device may include or consist of glass and/or plastic and/or ceramics, preferably solar glass, at least in certain areas.

It is possible that the device consists of several materials which are arranged in layers or areas, whereby the device consists at least in certain areas of a material which can absorb daylight and transmit it to the solar cells positioned on the lower side. Preferably the device consists completely of glass, especially solar glass, as it is usually used in photovoltaic technology. Compared to window glass, solar glass is characterized by a lower content in iron and/or iron oxide, which leads to a particularly high transmission for daylight. In addition, solar glass is chemically or thermally hardened and thus more break-resistant than standard window glass, for example against hail. Furthermore, solar glass is more resistant to temperature changes that are to be expected during the intended outdoor use of the device.

Another embodiment includes anti-reflective treated solar glass. Solar glass of class R2 for single-sided treated glass or a higher class is particularly preferred. In class R2 the transmission value is higher than 0.965.

The anti-reflective treatment causes a more effective use of light by reducing reflection losses.

In a further embodiment, particles with a maximum linear extension of less than 1.5 mm are arranged on the top surface of at least one structural element and preferably on all structural elements, at least in certain areas.

In a particularly preferred way the top surface of all structural elements is completely covered with particles that have a maximum linear extension of less than 1 mm and are distributed all over the top surface and rise slightly out of the top surface.

A according to the invention people should walk and/or drive on the device. The function of the particles is to increase the contact grip and slip resistance between the device and tire rubber and/or shoe soles. Thus, their function is to protect the device from wear caused by abrasion.

Preferably, the particles are applied to the top surfaces of the structural elements during the manufacture of the device. However, it is also possible that the particles are subsequently applied. The particles are firmly bonded to the surfaces. The particles are characterized in particular by the fact that their hardness is greater than the hardness of the material on which they are applied. Their Mohs hardness is preferably 8, especially preferably 9, and the particles are also characterized by their permeability to daylight. Particularly preferred are particles of corundum or a suitable alloy containing corundum.

In another embodiment, the device is characterized in that the top surface of at least one structural element comprises a microtexture.

Microtextures serve to optimize the slip resistance on the top surfaces of the structural elements as an alternative to particles. Preferably, all top surfaces of the structural elements are microtextured. It is imaginable that all surfaces of the device are provided with microtextures.

Microtextures can be applied both during the manufacturing process of the device or afterwards on the device. The texture can be applied by laser and/or blasting and/or printing and/or embossing.

Microtextures preferably have a maximum vertical extension of 1000 µm and a maximum horizontal extension of 1000 µm.

Another aspect of the present invention is a covering system for covering solar cells and/or at least one photovoltaic module, which comprises several devices according to the invention for covering solar cells and/or at least one photovoltaic module. The individual devices are arranged in a common plane, in particular at a distance of at least 3 mm from each other and are mechanically connected to each other.

Thus, a comprehensive system is made available which covers a relatively large area of a traffic route by several individual devices according to the invention. If necessary, the complete traffic route can be overlaid by the cover system according to the invention.

In addition a process is provided for the manufacture a device, according to the invention, for covering solar cells and/or at least one photovoltaic module, which comprises making available a raw piece of at least partially transparent material and forming structural elements on one side of the raw piece such that a maximum vertical extension H of a respective structural element in relation to a distance D of the respective structural element to the adjacent structural element yields a H/D-ratio, preferably with a value H/D < 6, in particular H/D < 1.5.

A further aspect of the invention is a photovoltaic system, comprising at least one device according to the invention for covering solar cells and/or at least one photovoltaic module and/or at least one covering system according to the invention, and at least one solar cell and/or at least one photovoltaic module, which is arranged on the lower side of the device or the covering system facing away from the upper side of the base body, so that light passing through the device or covering system can reach the solar cell or the photovoltaic module and can be converted there into electrical energy.

Such a photovoltaic system can thus also be used to carry out the other aspect of the invention in question, namely a process for generating electrical energy, in which light, in particular daylight, strikes the photovoltaic system, penetrates the device for covering solar cells and/or at least one photovoltaic module or module and is at least partially converted into electrical energy in a solar cell and/or one photovoltaic module.

The invention is explained below using the embodiment examples shown in the enclosed drawings.

It is shown in
- Fig. 1:: a three-dimensional schematic illustration of a transparent device for covering solar cells and/or at least one photovoltaic module,
- Fig. 2:: a schematic illustration of an embodiment of the transparent device for covering solar cells and/or at least one photovoltaic module in top view, and
- Fig. 3:: a schematic representation of a covering system for covering solar cells and/or at least one photovoltaic module in top view.

All figures show the coordinates x and y or x, y and z, that build the three-dimensional space in which the transparent device and the covering system is aligned. The coordinate system is rectangular. The x-y-plane corresponds to the normal horizontal plane. The z-direction extends vertical upwards from this plane.

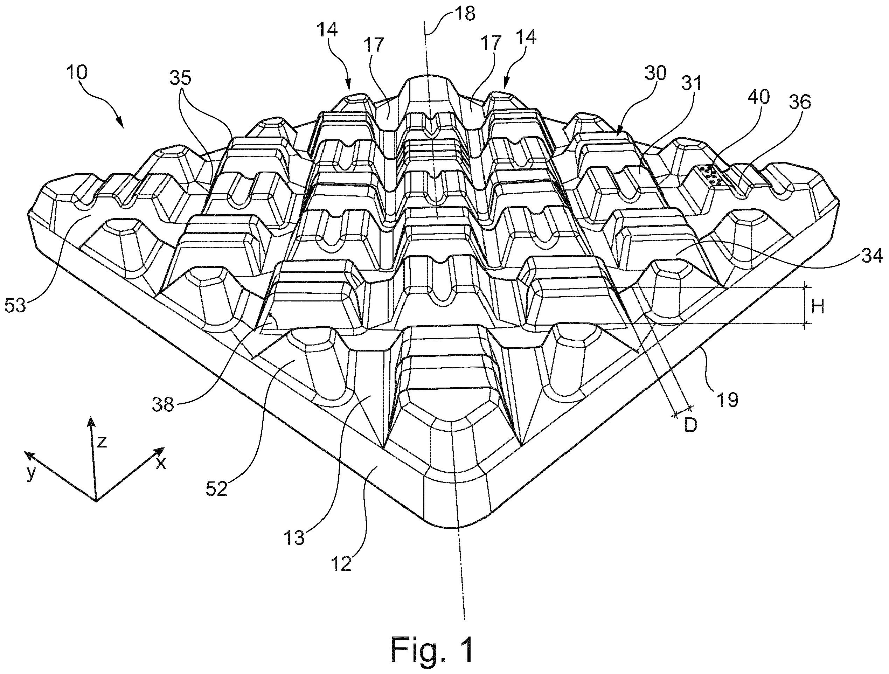

Figure 1 shows an embodiment of the transparent device 10 for covering solar cells and/or at least one photovoltaic module in a view from diagonally above. The device comprises a base body 12 with a lower side 19 and an upper side 13, which comprises a multiplicity of structural elements 30, whose base areas are designed as square surfaces with rounded corners and extend in the x-y-direction. The orientation in the x-y-direction corresponds to the orientation of the device 10 when used according to the invention to cover a road or a path. The base body 12 has the shape of a flat cuboid with rounded vertical side edges. A vertical central axis 18 in the z-direction is defined to explain the invention.

Structural elements 30 with square base areas are arranged on the upper side 13 of the base body 12. A special corner element 52 is arranged in each of the four corners. Three special edge elements 53 each are arranged in the area of the four edges of upper side 13.

The projection surface of structural elements 30 on the upper side 13 is a square for a structural element 30, a triangle for an edge element 53 and a projection surface composed of a square and a triangle for a corner element 52. The arrangement of structural elements 52, 53 at the corners and edges results from the complete covering of the upper side 13 with structural elements 30.

A structural element 30 with a square base has four side surfaces 34, which are angled at an angle 38 to the upper side 13. The structural element 30 is characterized by a vertical extension H in z-direction, which can also be described as height H of structural element 30. This means that the structural element 30 tapers in the z-direction. All structural elements 30, 52 and 53 have the same height within normal manufacturing tolerances and their side surfaces are angled at the same angle.

A typical structural element 30 with a square base has a notch 36, which extends downwards in the z-direction and narrows in the direction of the upper side 13. In the embodiment shown here, the notch 36 does not extend down to the upper side 13. Thus, the notch 36 is less deep than the vertical extension H of the structural element 30.

The four corner elements 52 have two parallel notches. Correspondingly, the corner elements 52 are designed with three surface areas. The edge elements 53 have no notches, so that they have one continuous surface each.

The structural elements are limited upwards in the vertical direction by their top surfaces 31. A typical structural element 30 with a square base is characterized in that the notch 36 runs parallel to two opposite side surfaces 34 of the respective structural element and extends over the entire structural element 30 in the x- or y- direction. The typical structural element 30 thus has two top surfaces 31 with essentially the same rectangular face.

The notches run at a 90° angle to each other within two adjacent structural elements. This rule applies in particular to the central structural element 30, through which the vertical axis 18 runs. The only exception is the row of structural elements 30 running from left to right in Figure 1, which lie on one of the diagonals of the upper side 13 running through the corner points of device 10. Here, the notches 36 of the corner elements 53 are aligned parallel to those of the respective adjacent typical structural element 30 with a square base area.

The transitions between the surfaces of the device, for example the transitions between side surface 34 and top surface 31 of the structural elements or the transition between side surface 34 and upper surface 13 of the base body 12, are provided with a radius 35, whereby the corners and edges of the device are rounded. This radius 35 does not have to be the same everywhere.

Particles 40, shown here as an example, are applied to the top surfaces 31 of the structural elements. All surfaces of structural elements 30, 52 and 53 are covered with particles 40 as shown here.

Two adjacent structural elements 30 are arranged with a distance D to each other. It can be seen that the distance D is not identical between all structural elements 30.

The upper side 13 is essentially covered with structural elements 30, corner elements 52 and edge elements 53. The structural elements 30, 52 and 53 are arranged in row arrangements 14 on the upper side 13 of the base body 12. Two rows of structural elements 30 run along the diagonals running through the corners of the upper side 13. The other rows of structural elements 30 run essentially parallel to the diagonals. Between the rows, channels 17 are formed by the distance D between the adjacent structural element rows. It can be seen that the channels 17 become wider as the distance D increases from the center of the upper side 13 to the edge.

With the exception of particle 40, device 10 is designed as one body and is made entirely of transparent material.

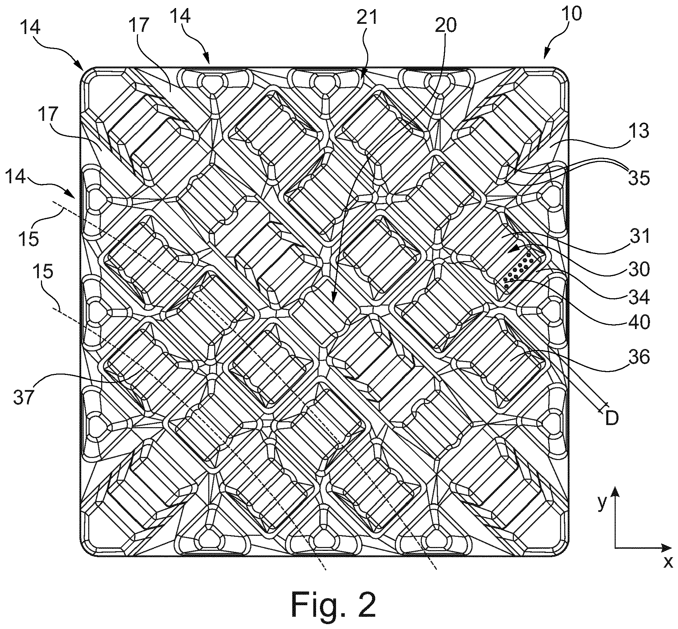

Figure 2 shows the same embodiment of the transparent device 10 as in Figure 1 in top view.

Among other things, a typical structural element 30 with a square base area with two areas of top surface 31 is shown, which are completely occupied by particles 40 (here only indicated). The structural element 30 with rectangular base has four side surfaces 34 and a notch 36. The corners and edges of all structural elements 30 shown are rounded with a radius 35. It can be seen that the notch 36 extends parallel to two side faces 34 of the respective structural element 30 and extends over the entire surface of structural element 30. The structural elements 30 are arranged on the upper side 13 of the base body 12, which extends vertically into the display plane. The structural elements 30 are arranged at a distance D from each other. The notches 36 of two adjacent structural elements 30 run at a 90° angle to each other. The only exceptions are the notches 36 of the corner elements 52 arranged parallel to the notches 36 of their adjacent structural element 30 on the diagonals running from bottom left to top right in the illustration.

The upper side 13 of the base body 12 of the device 10 is essentially covered with structural elements 30. In the edge region 21 of the square upper side 13, corner elements 52 are arranged in the corners and edge elements 53 at the edges. In addition, typical structural elements 30 with a square base area are arranged on the upper side 13.

The structural elements 30 are arranged in row arrangements 14. Each projected area of a structural element 30 with a square base area has a center of area 37 of its surface on the upper side 13.

The non-linear interpolation of the centers of area 37 of a respective row results in a straight line for the diagonal rows of structural elements 30 running through the corner points of device 10. The side surfaces of the structural elements 30 are in alignment with each other.

For the rows adjacent to linear rows, the non-linear interpolation of the centers of gravity 37 results in a second order curve 15. It can be seen that the structural elements 30 are arranged such that the opposite side surfaces 34 of two adjacent structural elements 30 have a slight shift to the row arrangement.

Channels 17 are formed on both sides of the diagonal and linear rows of structural elements 30, which extend from the central region 20 to the edge region 21. The device 10 has 8 channels in total.

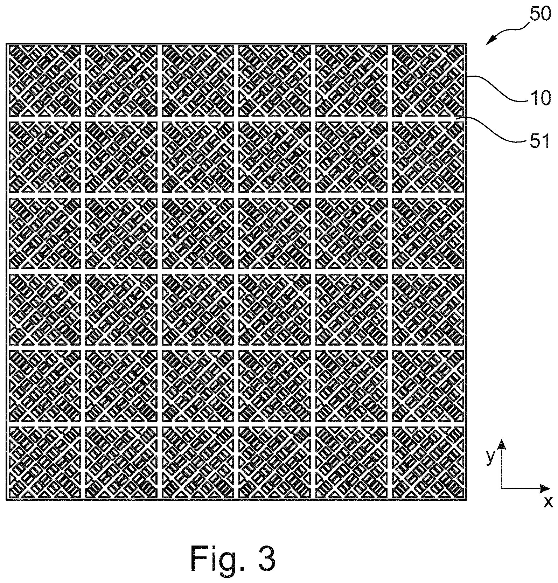

Figure 3 shows in top view a cover system 50, which extends in x-y-direction and consists of 6x6 transparent devices 10. The devices 10 are arranged at a distance 51 from each other. The devices 10 are arranged in a grid in such a way that the edges of the transparent devices 10 are parallel to each other and a square base area results for the covering system 50. The devices 10 are mechanically connected (not shown). It can be seen that the devices 10 are designed symmetrically so that it is irrelevant for a correct assembly of the covering system 50 which sides of two devices 10 are arranged next to each other or are arranged opposite to each other.

### List of characters

- 10: device
- 12: base body
- 13: upper side
- 14: row arrangement
- 15: second-order curve
- 17: channel
- 18: vertical central axis
- 19: lower side
- 20: central region
- 21: edge region
- 30: structural element
- 31: top surface
- 34: side surface
- 35: radius
- 36: notch
- 37: center of area of projection
- 38: angle
- 40: particles
- 50: covering system
- 51: distance
- 52: corner element
- 53: edge element
- H: vertical extension
- D: distance

## Claims

1. Transparent device (10) for covering solar cells and/or at least one photovoltaic module, having a base body (12) extending essentially in one plane, on whose upper side (13) a plurality of structural elements (30) are arranged, each having at least one top surface (31) facing away from the upper side (13) of the base body (12),
**characterized in that**
the ratio H/D, defined by a maximum vertical extension H of a respective structural element (30) and a distance D of the respective structural element (30) to the adjacent structural element (30) is limited by H/D < 6, in particular by H/D < 1.5.

2. Transparent device (10) for covering solar cells and/or at least one photovoltaic module according to claim 1,
**characterized in that**
the maximum vertical extension H of a structural element (30) is at least 1.5 mm.

3. Transparent device (10) for covering solar cells and/or at least one photovoltaic module according to at least one of the preceding claims,
**characterized in that**
at least one side surface (34) of a respective structural element (30) is at least partially angled on the circumferential surface of the respective structural element (30) at an angle (38) of at most 75° with respect to the upper side (13) of the base body (12), so that the respective structural element (30) is tapered upwards when the device (10) is aligned horizontally.

4. Transparent device (10) for covering solar cells and/or at least one photovoltaic module according to at least one of the preceding claims,
**characterized in that**
at least one of the structural elements (30) has at least one notch (36) on its respective top surface (31) facing away from the upper side (13) of the base body (12).

5. Transparent device (10) for covering solar cells and/or at least one photovoltaic module according to at least one of the preceding claims,
**characterized in that**
a plurality of structural elements (30) is arranged in a row arrangement (14), in which at least some of these structural elements (30) arranged in rows and adjacent to one another are staggered to one another in such a way that a non-linear interpolation of the centers of area (37) of their projected area onto the upper side (13) of the base body (12) describes a second-order curve (15).

6. Transparent device (10) for covering solar cells and/or at least one photovoltaic module according to at least one of the preceding claims,
**characterized in that**
several structural elements (30) form an element grid and form between the row arrangements (14) of structural elements (30) partially at least one channel (17), that widens from a central region (20) of the device towards its edge region (21).

7. Transparent device (10) for covering solar cells and/or at least one photovoltaic module according to one of the preceding claims,
**characterized in that**
the structural elements (30) are arranged on the device (10) such that the profile of the device (10) in each vertical section along a vertical central axis (18) of the device (10) is substantially axially symmetric to the vertical central axis (18) of the device (10).

8. Transparent device (10) for covering solar cells and/or at least one photovoltaic module according to at least one of the preceding claims,
**characterized in that**
the device (10) consists at least in certain areas of a transparent material having a transmittance of at least 0.8, in particular for daylight.

9. Transparent device (10) for covering solar cells and/or at least one photovoltaic module according to at least one of the preceding claims,
**characterized in that**
the device (10), in particular the structural element (30), is at least in certain regions made of a material with a Mohs hardness of at least 5.5 and/or an abrasion resistance of at least class 4.

10. Transparent device (10) for covering solar cells and/or at least one photovoltaic module according to at least one of the preceding claims,
**characterized in that**
the device (10) comprises glass and/or plastic and/or ceramics, preferably solar glass, at least in certain regions.

11. Transparent device (10) for covering solar cells and/or at least one photovoltaic module according to at least one of the preceding claims,
**characterized in that**
particles (40) with a maximum linear expansion of less than 1.5 mm are arranged on the top surface (31) of at least one structural element (30) at least in certain regions.

12. Covering system (50) for covering solar cells and/or at least one photovoltaic module, comprising several devices (10) for covering solar cells and/or at least one photovoltaic module according to at least one of claims 1-11,
**characterized in that**
the individual devices (10) are arranged in a common plane, in particular at a distance (51) of at least 3 mm, from one another and are mechanically connected to one another.

13. Method of manufacturing a device for covering solar cells and/or at least one photovoltaic module according to at least one of the claims 1- 11 with the following steps:
- Provision of a blank of at least partially transparent material,
- generating structural elements (30) on one side of the blank such that the ratio H/D, defined by a maximum vertical extension H of a respective structural element (30) and a distance D of the respective structural element (30) to the adjacent structural element (30) is limited by H/D < 6, in particular by H/D < 1.5.

14. Photovoltaic system, comprising at least one device (10) for covering solar cells and/or at least one photovoltaic module according to one of claims 1 - 11 and/or at least one covering system (50) according to claim 12, and at least one solar cell and/or at least one photovoltaic module which is mounted on a bottom side (19) of the device (10) facing away from the top side (13) of the basic body (12), or of the covering system (50) so that light passing through the device (10) or the covering system (50) can reach the solar cell or the photovoltaic module and be converted into electrical energy there.

15. Process for generating electrical energy using a photovoltaic system according to claim 14, **characterized in that** light, in particular daylight, impinging on the photovoltaic system, penetrates the device (10) for covering solar cells and/or at least one photovoltaic module according to the claims 1 to 11 or the module according to claim 12 and is at least partially converted into electrical energy in a solar cell and/or a photovoltaic module.
